(19) **Europäisches Patentamt European Patent Office Office européen des brevets**

(11) **EP 4 486 061 A1**

(12) **EUROPEAN PATENT APPLICATION**
published in accordance with Art. 153(4) EPC

(43) Date of publication:
01.01.2025 Bulletin 2025/01

(21) Application number: 23759573.1

(22) Date of filing: 26.01.2023

(51) International Patent Classification (IPC):
$H05B\ 6/68^{(2006.01)}$      $F24C\ 7/02^{(2006.01)}$

(52) Cooperative Patent Classification (CPC):
H05B 6/705; F24C 7/02; H05B 6/68; H05B 6/686

(86) International application number:
PCT/JP2023/002465

(87) International publication number:
WO 2023/162567 (31.08.2023 Gazette 2023/35)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 24.02.2022 JP 2022026943

(71) Applicant: Panasonic Intellectual Property
Management Co., Ltd.
Kadoma-shi, Osaka 571-0057 (JP)

(72) Inventors:
• TAKANO, Shinji
Osaka 571-0057 (JP)
• UNO, Takashi
Osaka 571-0057 (JP)
• FUKUI, Mikio
Osaka 571-0057 (JP)

(74) Representative: SSM Sandmair
Patentanwälte Rechtsanwalt
Partnerschaft mbB
Joseph-Wild-Straße 20
81829 München (DE)

(54) **RADIO WAVE EMITTING DEVICE**

(57) In a radio wave emitting apparatus of the present disclosure, a radio wave emitter emits traveling waves into a cavity. A temperature measurer measures a temperature of the signal amplifier. An electric power measurer measures a reflected-wave electric power. A controller (7) executes a first control process and a second control process. In the first control process, a target value of a traveling-wave electric power is set to a first electric power. The second control process includes one or more first periods during which the target value of the traveling-wave electric power is set to the first electric power, and one or more second periods during which the target value of the traveling-wave electric power is set to a second electric power that is less than the first electric power. In the second control process, the one or more first periods and the one or more second periods are repeated alternately one by one. The controller executes the second control process when the temperature of the signal amplifier exceeds a specified temperature during execution of the first control process.

FIG. 1

EP 4 486 061 A1

## Description

### TECHNICAL FIELD

The present disclosure relates to a radio wave emitting apparatus.

### BACKGROUND ART

In recent years, a heating apparatus as a radio wave emitting apparatus that provides high frequency radio waves using a semiconductor oscillator element is known (see PTL 1). This type of heating apparatus includes a heating chamber for accommodating an object to be heated, a high frequency generator, a detector, and a controller.

The high frequency generator includes a semiconductor oscillator element and generates radio waves with a given selected frequency in a predetermined frequency band. The detector is disposed between the high frequency generator and the heating chamber to detect traveling-wave electric power and reflected-wave electric power. The controller controls the output power level and the phase of the high-frequency electric power based on the values detected by the detector.

### CITATION LIST

#### Patent Literature

PTL 1: International Publication No. 2014/188422

### SUMMARY

The high frequency generator includes a signal amplifier that amplifies the high frequency signals generated by the semiconductor oscillator element. The signal amplifier is a heat generating element. For this reason, it is important to prevent an excessive temperature rise of the signal amplifier.

One method of achieving this is to reduce the traveling-wave electric power. However, when the traveling-wave electric power reduces, the reflected-wave electric power accordingly reduces. Therefore, this method may become a cause of stability deterioration in various processes that utilize the reflected-wave electric power.

It is an object of the present disclosure to provide a radio wave emitting apparatus that is able to prevent an excessive temperature rise in the signal amplifier and to improve stability of the processes that are based on reflected waves.

A radio wave emitting apparatus according to an embodiment of the present disclosure includes a signal generator, a signal amplifier, a radio wave emitter, a temperature measurer, an electric power measurer, and a controller.

The signal generator generates a high frequency signal having a given frequency in a predetermined frequency band. The signal amplifier amplifies the high frequency signal to generate a high frequency electric power. The radio wave emitter emits a traveling wave corresponding to the high frequency electric power to an object. The temperature measurer measures a temperature of the signal amplifier. The electric power measurer measures a reflected-wave electric power, which is the electric power of a reflected wave of the traveling wave that flows back toward the signal generator. The controller controls the signal generator and the signal amplifier.

The controller is able to execute a first control process and a second control process. The first control process includes setting a target value of a traveling-wave electric power, which is the electric power of the traveling wave, to a first electric power. The second control process includes providing one or more first periods during which the target value of the traveling-wave electric power is set to the first electric power, and one or more second periods during which the target value of the traveling-wave electric power is set to a second electric power that is less than the first electric power. The second control process includes repeating the one or more first periods and the one or more second periods alternately one by one. The controller executes the second control process when the temperature of the signal amplifier exceeds a specified temperature during execution of the first control process.

According to the present disclosure, it is possible to prevent an excessive temperature rise in the signal amplifier and to improve stability of the processes that are based on the reflected wave.

### BRIEF DESCRIPTION OF THE DRAWINGS

Fig. 1 is a schematic view illustrating the configuration of a radio wave emitting apparatus according to a first exemplary embodiment of the present disclosure.

Fig. 2 is a flowchart illustrating an example of operation of a controller in the radio wave emitting apparatus according to the first exemplary embodiment.

Fig. 3 is a waveform chart illustrating an example of operation of the controller in the radio wave emitting apparatus according to the first exemplary embodiment.

Fig. 4 is a graph illustrating a first example of time variation of a reflection rate for each frequency.

Fig. 5 is a graph illustrating a second example of time variation of a reflection rate for each frequency.

Fig. 6 is a waveform chart illustrating an example of operation of a controller in a radio wave emitting apparatus according to a second exemplary embodiment of the present disclosure.

Fig. 7 is a waveform chart illustrating an example of operation of a controller in a radio wave emitting apparatus according to a third exemplary embodiment of the present disclosure.

Fig. 8 is a waveform chart illustrating an example of operation of a controller in a radio wave emitting apparatus according to a fourth exemplary embodiment of the present disclosure.

## DESCRIPTION OF EMBODIMENTS

Hereinbelow, exemplary embodiments will be described in detail with reference to the drawings. However, detailed description of well-known matters and repetitive description of substantially the same structures may be omitted.

First Exemplary Embodiment

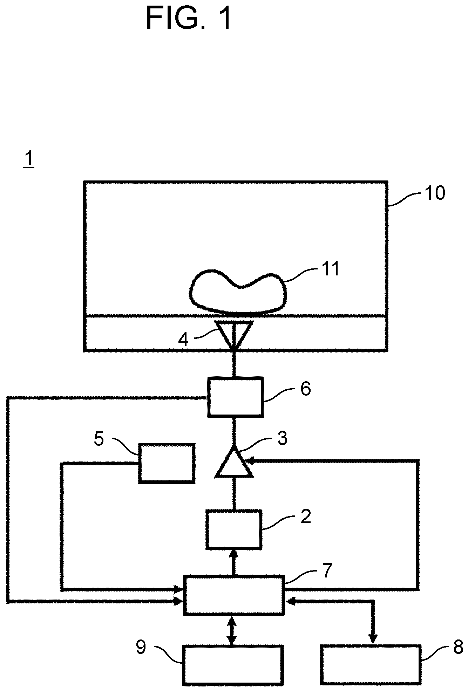

Fig. 1 is a schematic view illustrating the configuration of radio wave emitting apparatus 1 according to a first exemplary embodiment of the present disclosure. Radio wave emitting apparatus 1 includes signal generator 2, signal amplifier 3, radio wave emitter 4, temperature measurer 5, electric power measurer 6, controller 7, memory storage 8, input/output unit 9, and cavity 10.

Cavity 10 accommodates object 11, such as food. Radio wave emitting apparatus 1 is, for example, a microwave oven, and emits radio waves to object 11 to thereby heat object 11.

As illustrated in Fig. 1, cavity 10 has a rectangular parallelepiped shape and includes wall surfaces (left wall surface, right wall surface, bottom wall surface, top wall surface, and back wall surface) that are made of a radio wave shielding material, and a door that covers the front opening of cavity 10.

In the present disclosure, the term "shielding" means to reduce radio wave energy by absorption, or to confine radio waves within cavity 10 by reflection, multiple reflection, or the like. Examples of the radio wave shielding material include materials that reflect radio waves, such as metallic materials, and materials that absorb radio waves, such as ferrite rubber.

Signal generator 2 generates a high frequency signal having a given frequency within a predetermined frequency band according to instructions from controller 7. The frequency band of the high frequency signal is, for example, 300 MHz to 10 GHz. Radio wave emitting apparatus 1 emits radio waves according to high frequency electric power generated by amplifying the high frequency signal within the just-mentioned frequency band to thereby dielectrically heat an object.

In the present exemplary embodiment, signal generator 2 is able to be operated by a commercial power source, includes a voltage controlled oscillator, and generates a high frequency signal. When a plurality of high frequency signals are to be generated in a wider frequency band, signal generator 2 may include a phase-locked loop (PLL) frequency synthesizer.

Signal amplifier 3 amplifies the high frequency signal from signal generator 2 and generates high frequency electric power. For example, signal amplifier 3 includes a laterally diffused metal oxide semiconductor (LDMOS) transistor, or a high electron mobility transistor, such as a gallium arsenide (GaAs) transistor or a gallium nitride (GaN) transistor.

Radio wave emitter 4 may be, for example, an antenna that can operate so as to emit radio waves into cavity 10 based on the high frequency electric power generated by signal amplifier 3. As illustrated in Fig. 1, radio wave emitter 4 is disposed, for example, below the bottom wall surface of cavity 10 to emit radio waves into cavity 10.

Temperature measurer 5 measures temperature Ta of signal amplifier 3 and transmits the information thereof to controller 7. Temperature measurer 5 includes, for example, a temperature sensor disposed near signal amplifier 3. The measured temperature Ta of signal amplifier 3 does not need to be the true temperature of signal amplifier 3 but may be a temperature that can be considered as the temperature of signal amplifier 3. Temperature measurer 5 may be composed of a known temperature sensor.

Electric power measurer 6 is connected between signal amplifier 3 and radio wave emitter 4. Electric power measurer 6 is composed of, for example, a directional coupler. Electric power measurer 6 measures the electric power of the radio wave that is emitted from radio wave emitter 4 according to the high frequency electric power generated by signal amplifier 3, and transmits the information thereof to controller 7. Hereinafter, the radio wave emitted from radio wave emitter 4 is referred to as a traveling wave, and the electric power of the traveling wave is referred to as a traveling-wave electric power.

Electric power measurer 6 also measures the electric power of a reflected wave, not just the traveling-wave electric power, and the information thereof to controller 7. The reflected wave is, for example, a radio wave that is not emitted from radio wave emitter 4 into cavity 10 due to impedance mismatch but flows back toward signal generator 2.

The reflected wave also includes, among the traveling wave emitted into cavity 10, a radio wave that is reflected within cavity 10 without being absorbed by object 11 or the like and flows back toward signal generator 2 via radio wave emitter 4. Hereinafter, the electric power of the reflected wave is referred to as reflected-wave electric power.

Memory storage 8 is a memory storage device that stores information that is utilized by controller 7 and information that is generated by controller 7. Memory storage 8 includes one or more non-transitory memory storage media. In the present exemplary embodiment, the memory storage medium is a semiconductor memory, such as a flash memory.

The memory storage medium may be any of hard disk drive, optical drive, and SSD (solid state drive). The memory storage medium may be any of internal type, external type, and NAS (network-attached storage) type.

Input/output unit 9 has the functions as an input device for inputting information from the user and as an output device for outputting information to the user. In other words, input/output unit 9 is an human-machine interface in radio wave emitting apparatus 1.

Specifically, input/output unit 9 includes, for example, an input device such as a mechanical switch, a touchpad, and a microphone, an output device such as a display and a speaker, and an input/output device such as a touchscreen panel.

Input/output unit 9 includes a communication interface. The communication interface communicates with an external central device or terminal device by a given communication mode to input information to radio wave emitting apparatus 1 and to output information from radio wave emitting apparatus 1.

Examples of the external central device include an industrial computer that functions as a communication network master, a device that incorporates and controls the radio wave emitting apparatus, and the like. Examples of the terminal device include a personal computer, a smartphone, a tablet computer, a wearable device, and the like that are owned by the user.

Controller 7 controls signal generator 2 and signal amplifier 3 to execute a plurality of control processes for emitting a radio wave to object 11 inside cavity 10. Controller 7 may be composed of, for example, a microcontroller including one or more processors and memories. Controller 7 may also be composed of a FPGA (field-programmable gate array), an ASIC (application specific integrated circuit), or the like.

Controller 7 controls the traveling-wave electric power by, for example, controlling the magnitude of the high frequency signal generated by signal generator 2. Controller 7 may also control the traveling-wave electric power by changing the amplification factor of signal amplifier 3, by changing the voltage of the internal power supply connected to signal amplifier 3, or the like. For example, controller 7 may allow a variable attenuator to change the amplification factor of signal amplifier 3.

Controller 7 selects an appropriate frequency from the frequency band that is usable for dielectric heating. Controller 7 controls the frequency of the traveling wave by instructing signal generator 2 which frequency of the high frequency signal is to be generated.

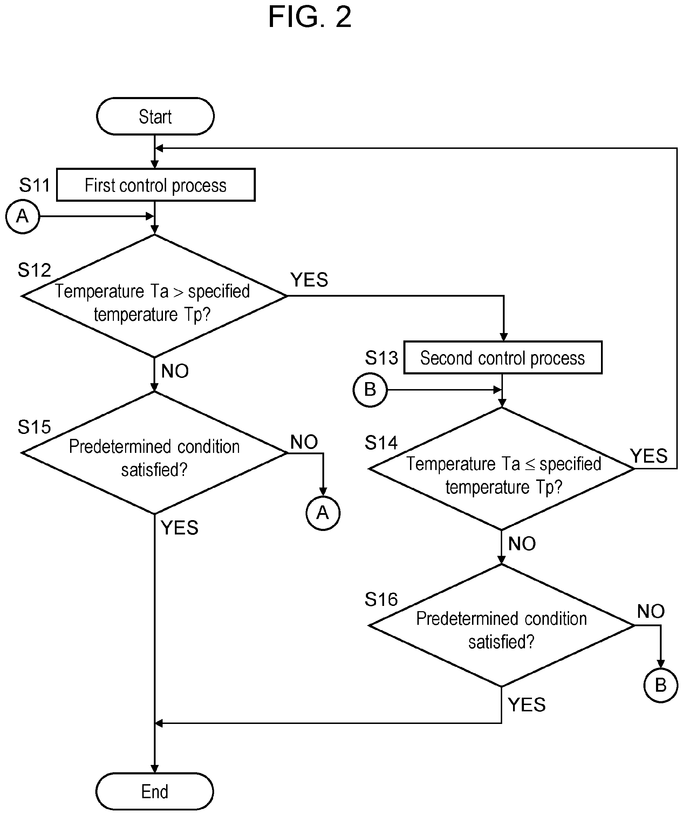

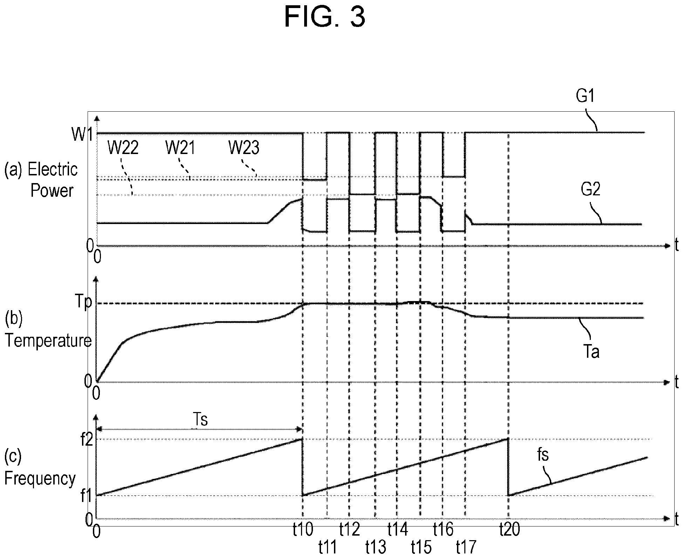

Hereinbelow, the operation of controller 7 in the present exemplary embodiment will be described with reference to Figs. 2 and 3. Fig. 2 is a flowchart illustrating an example of operation of controller 7. Fig. 3 is a waveform chart illustrating an example of operation of controller 7. In Fig. 3, reference characters G1, G2, Ta, and fs represent the traveling-wave electric power, the reflected-wave electric power, the temperature of signal amplifier 3, and the frequency of the traveling wave, respectively.

In the present exemplary embodiment, the plurality of control processes executed by controller 7 include a first control process (step S11 of Fig. 2) and a second control process (step S13 of Fig. 2).

In each of the first control process and the second control process, signal generator 2 generates a high frequency signal while performing a frequency sweep according to instructions from controller 7. The term "frequency sweep" means repeatedly and periodically changing the frequency of the high frequency signal to be output over a predetermined frequency band.

In radio wave emitting apparatus 1, different radio wave distributions are formed inside cavity 10 according to the frequency of the traveling wave. Meanwhile, the frequency appropriate for processing object 11 varies depending on the type or the like of object 11. The present exemplary embodiment enables appropriate processing according to the type of object 11 by the frequency sweep.

As illustrated in the example shown in Fig. 3, in the frequency sweep, frequency fs of the traveling wave increases by every 1 MHz from the lower limit frequency f1 to the upper limit frequency f2 in a predetermined frequency band (see waveform (c) in Fig. 3). The predetermined frequency band is, for example, 2400 MHz to 2499 MHz.

The order of frequency in the frequency sweep is not limited to that described above, but may be such that each frequency within the predetermined frequency band is necessarily selected one time during period Ts consequently. In other words, in the frequency sweep, the frequency may not necessarily be varied continuously, but, for example, the order of each frequency selected within the predetermined frequency band may be determined randomly.

The first control process (step S11 of Fig. 2) is a process with its primary purpose of emitting a radio wave to object 11. The first control process includes setting the target value of traveling-wave electric power G1 to first electric power W1 (see waveform (a) in Fig. 3).

First electric power W1 is determined according to, for example, the content of the processing to be performed for object 11. First electric power W1 may be, for example, 250 W. In the first control process, the frequency of the traveling wave varies, but the traveling-wave electric power is constant.

Controller 7 determines whether or not temperature Ta exceeds specified temperature Tp (see waveform (b) in Fig. 3) (step S12 of Fig. 2) during execution of the first control process. If temperature Ta exceeds specified temperature Tp (YES in step S12 of Fig. 2), controller 7 switches the operation of radio wave emitting apparatus 1 from the first control process to the second control process (step S13 of Fig. 2).

Specified temperature Tp is a threshold temperature that is determined to maintain temperature Ta within the range in which signal amplifier 3 is able to operate stably. Specified temperature Tp may be, for example, 85 degrees. Temperature Ta may increase due to an increase of the reflected-wave electric power inside cavity 10, not just due to the heat generated by signal amplifier 3 itself.

In the example of Fig. 3, at time t10, controller 7 determines that temperature Ta has exceeded specified temperature Tp during execution of the first control process, and accordingly switches the operation of radio wave emitting apparatus 1 from the first control process to the second control process (see waveforms (a) and (b) in Fig. 3).

A primary purpose of the second control process (step S13 of Fig. 2) is to enable emission of a radio wave to object 11 to continue while preventing a temperature rise of signal amplifier 3. The second control process includes repeating one or more first periods and one or more second periods alternately one by one so that temperature Ta is maintained to a target temperature that is lower than or equal to specified temperature Tp. In the present exemplary embodiment, the target temperature matches specified temperature Tp. However, considering margins, the target temperature may be lower than specified temperature Tp.

In the first period, controller 7 sets the target value of the traveling-wave electric power to first electric power W1. In other words, in the first period, controller 7 executes the same process as the first control process. In waveform (c) of Fig. 3, a period from time t11 to t12, a period from time t13 to t14, and a period from time t15 to t16 correspond to the first period.

In the second period, controller 7 sets the target value of the traveling-wave electric power to a second electric power that is less than first electric power W1. The second control process includes adjusting the second electric power so that temperature Ta is maintained to the target temperature (specified temperature Tp herein). In waveform (c) of Fig. 3, a period from time t10 to t11, a period from time t12 to t13, a period from time t14 to t15, and a period from time t16 to t17 correspond to the second period.

In the present exemplary embodiment, the phrase "adjusting the second electric power" means to set one of second electric powers W21, W22, and W23, which are lower than first electric power W1, to the target value of traveling-wave electric power G1.

As indicated by waveform (c) of Fig. 3, the target value of traveling-wave electric power G1 is set to second electric power W21 from time t10 to t11. From time t12 to t13, the target value of the traveling-wave electric power G1 is set to second electric power W22. From time t14 to t15, the target value of the traveling-wave electric power G1 is set to second electric power W22. From time t16 to t17, the target value of the traveling-wave electric power G1 is set to second electric power W23. Here, second electric power W21 is higher than second electric power W22 and lower than second electric power W23.

In the present exemplary embodiment, controller 7 determines the second electric power, which is the target value of traveling-wave electric power G1, based on reduction amount D of the electric power that is necessary to maintain temperature Ta at the target temperature in cycle period Ts, which is a cycle period of a change of the radio wave frequency. Reduction amount D is obtained, for example, according to the following equation (1). In equation (1), $D_i$ represents an amount of decrease of electric power per one frequency. Amount of decrease $D_i$ is obtained, for example, according to the following equation (2).

**[Eq. 1]**

$$D = \sum_i D_i \qquad (1)$$

$$D_i = 10 \times \log_{10} Pdet_i - 10 \times \log_{10}(Pdet_i - Pdown_i) \qquad (2)$$

$Pdet_i$ [W] represents the traveling-wave electric power. $Pdown_i$ [W] is obtained by: $Pdown_i = (Ta - Tq) \times 1/Z$. Tq is the target temperature, and Z is the thermal resistance of signal amplifier 3. The thermal resistance of signal amplifier 3 is represented by, for example, the thermal resistance between the junction of the semiconductor element of signal amplifier 3 and the case of signal amplifier 3.

Electric power $D_s$ that needs to be reduced from the first electric power in a second period is obtained by: $D_i/X$, where X is the number of frequency steps of the radio wave emitted in the second period. Accordingly, the second electric power is set to a value obtained by subtracting electric power $D_s$ from first electric power W1.

In the second control process, controller 7 causes signal generator 2 and signal amplifier to perform the operation as described above repeatedly. In the present exemplary embodiment, each of the one or more first periods is associated with one corresponding frequency in the predetermined frequency band. Each of the one or more second periods is associated with one corresponding frequency in the predetermined frequency band. As indicated by waveform (c) of Fig. 3, respective frequencies from 2400 MHz to 2499 MHz are assigned to 10 periods between time t10 and t20.

That is, the period from time t10 to t11 is assigned to frequencies from 2400 MHz to 2409 MHz. The period from time t11 to t12 is assigned to frequencies from 2410 MHz to 2419 MHz. The period from time t12 to t13 is assigned to frequencies from 2420 MHz to 2429 MHz. The period from time t13 to t14 is assigned to frequencies from 2430 MHz to 2439 MHz. The period from time t14 to t15 is assigned to frequencies from 2440 MHz to 2449 MHz.

The period from time t15 to t16 is assigned to frequencies from 2450 MHz to 2459 MHz. The period from time t16 to t17 is assigned to frequencies from 2460 MHz to 2469 MHz. The period from time t17 to t18 is assigned to frequencies from 2470 MHz to 2479 MHz. The period from time t18 to t19 is assigned to frequencies from 2480 MHz to 2489 MHz. The period from time t19 to t20 is assigned to frequencies from 2490 MHz to 2499 MHz.

Which one of frequencies in the predetermined frequency band should be associated with each of the one or more first periods is determined depending on the type of object 11. Likewise, which one of frequencies in the predetermined frequency band should be associated with each of the one or more second periods is also determined depending on the type of object 11. Hereinafter, the just-described associating is referred to as associating each of the one or more first periods (or each of the one or more second periods) with a corresponding one of the frequencies in the predetermined frequency band.

In the present exemplary embodiment, memory storage 8 stores a data table indicating the above-described associating for each type of object 11. Based on the just-mentioned data table, controller 7 recognizes which frequency is associated with each of the one or more first periods and which frequency in the predetermined frequency band is associated with each of the one or more second periods.

In particular, at least one of the one or more first periods is associated with a specific frequency within the predetermined frequency band. The specific frequency is a frequency at which a time variation of the reflected-wave electric power indicates a change in the condition of object 11.

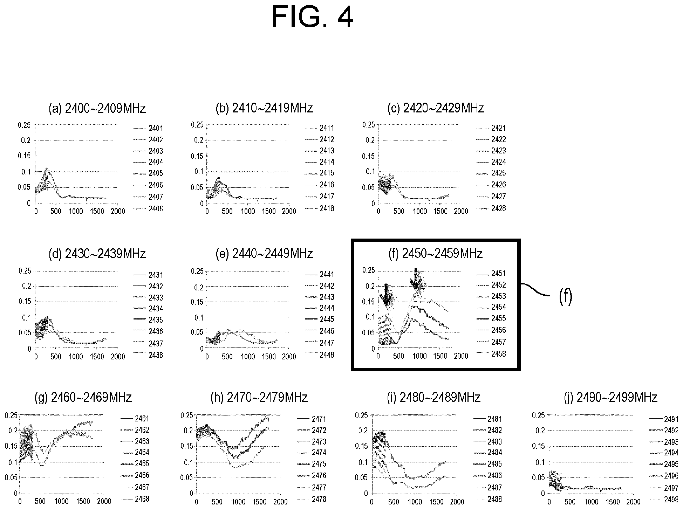

Fig. 4 is a graph illustrating a first example of time variation of a reflection rate with respect to the traveling wave for each frequency. In Fig. 4, the horizontal axis represents time [sec.] from the start of processing, and the vertical axis represents reflection rate [dimensionless]. The term "reflection rate" refers to the ratio of the reflected-wave electric power of the wave that returns as reflected wave of the traveling-wave electric power of the wave that is emitted as traveling wave. In other words, the reflection rate refers to the ratio of the reflected-wave electric power to the traveling-wave electric power. Controller 7 calculates the reflection rate from the traveling-wave electric power and the reflected-wave electric power.

The first example is for cooking a choux pastry using swelling detection. For cooking a choux pastry, heating to object 11 and condition detection for object 11 are performed simultaneously. For heating to object 11, dielectric heating and radiation heating are used in combination. It should be noted that radio wave emitting apparatus 1 also includes a component for radiation heating such as a tube heater, not only the components for dielectric heating as shown in Fig. 1. The details of the condition detection will be described later.

In the first example, the primary heating means is radiation heating, and dielectric heating assists radiation heating. The predetermined frequency band is 2400 MHz to 2499 MHz, and the frequency of the traveling wave is varied by every 1 MHz. In this case, the condition change of object 11 is swelling of object 11.

As shown in graph (f) in Fig. 4, two peaks indicated by the two arrows are observed in the time variation of the reflection rate for each frequency within the range of 2450 MHz to 2459 MHz. In particular, the peak at or around 1000 seconds later from the start of processing is associated with swelling of choux pastry. In other words, in the first example shown in Fig. 4, it is believed that the frequency that causes swelling of choux pastry is contained within the range of 2450 MHz to 2459 MHz.

In the first example, the frequency range for auxiliary heating is different from the frequency range for which condition detection is carried out. The frequency range used for auxiliary heating is 2400 MHz to 2499 MHz, which includes a sufficient frequency band and a sufficient number of frequency steps (100 steps).

Another example is for cooking a souffle using swelling detection. For cooking a souffle, heating to object 11 and condition detection for object 11 are performed simultaneously. For heating to object 11, dielectric heating and radiation heating are used in combination. The primary heating means is radiation heating, and dielectric heating assists radiation heating.

In the first example, the predetermined frequency band is 2400 MHz to 2499 MHz, and the frequency steps are 100 steps. The condition change of object 11 in this case is swelling of object 11. For cooking a souffle, the frequency that causes swelling thereof is contained within the range of 2460 MHz to 2479 MHz.

In this example as well, the frequency range for auxiliary heating is different from the frequency range for which condition detection is carried out. The frequency range used for auxiliary heating is 2400 MHz to 2499 MHz, which includes a sufficient frequency band and a sufficient number of frequency steps (100 steps).

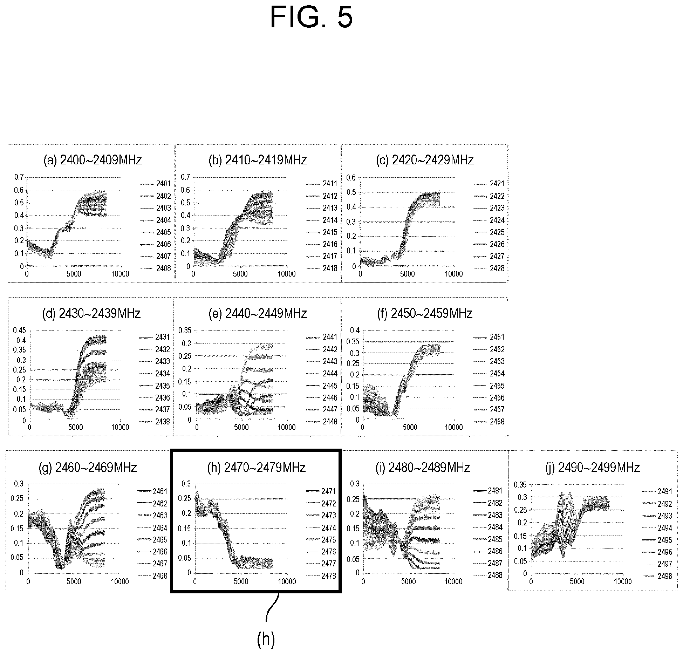

Fig. 5 is a graph illustrating a second example of time variation of a reflection rate with respect to the traveling wave for each frequency. In Fig. 5, the horizontal axis represents time [sec.] from the start of processing, and the vertical axis represents reflection rate [dimensionless].

The second example is for cooking dried fruits using drying detection. For cooking dried fruits, heating to object 11 and condition detection for object 11 are performed simultaneously. For heating to object 11, dielectric heating and radiation heating are used in combination.

In the second example, the primary heating means is radiation heating, and dielectric heating assists radiation heating. The predetermined frequency band is 2400 MHz to 2499 MHz, and the frequency of the traveling wave is varied by every 1 MHz. In this case, the condition change of object 11 is drying of object 11.

As indicated by graph (h) in Fig. 5, it is observed that the reflection rate has changed little from about 6000 seconds at each frequency in the range of 2470 MHz to 2479 MHz. This means that, in the second example shown in Fig. 5, it is believed that the frequency that indicates that object 11 has been dried is contained within the range of 2470 MHz to 2479 MHz.

In the second example as well, the frequency range for auxiliary heating is different from the frequency range for which condition detection is carried out. The frequency range used for auxiliary heating is 2400 MHz to 2499 MHz, which includes a sufficient frequency band and a sufficient number of frequency steps (100 steps).

Referring back to Fig. 2, after the second control process (step S13 of Fig. 2), controller 7 determines whether or not temperature Ta no longer exceeds specified temperature Tp (step S14 of Fig. 2) during execution of the second control process. If controller 7 determines that temperature Ta no longer exceeds specified temperature Tp during execution of the second control process (YES in step S14 of Fig. 2), controller 7 switches the operation of radio wave emitting apparatus 1 from the second control process to the first control process (step S 11 of Fig. 2).

In the present exemplary embodiment, controller 7 determines that temperature Ta does not exceed specified temperature Tp when temperature Ta continues to be lower than or equal to specified temperature Tp for a predetermined time during execution of the second control process. However, it is also possible that controller 7 may immediately determine that temperature Ta no longer exceeds specified temperature Tp when temperature Ta becomes lower than or equal to specified temperature Tp during execution of the second control process.

Controller 7 may immediately determine that temperature Ta no longer exceeds specified temperature Tp when temperature Ta becomes lower than or equal to a predetermined threshold temperature that is lower than specified temperature Tp during execution of the second control process. In other words, the threshold temperature for determining switching the operation of radio wave emitting apparatus 1 from the second control process to the first control process may be different from specified temperature Tp. Specified temperature Tp is the temperature for determining switching the operation of radio wave emitting apparatus 1 from the first control process to the second control process.

If specified temperature Tp is the threshold temperature, there is a possibility that the switching between the first control process and the second control process is repeated frequently due to errors or the like. For this reason, by setting the threshold temperature to be lower than specified temperature Tp, the operation of radio wave emitting apparatus 1 can be stabilized.

In Fig. 3, at time t17, controller 7 determines that temperature Ta no longer exceeds specified temperature Tp during execution of the second control process (YES in step S14 of Fig. 2), so controller 7 switches the operation of radio wave emitting apparatus 1 from the second control process to the first control process (step S11 of Fig. 2).

When controller 7 has not determined that temperature Ta exceeds specified temperature Tp during execution of the first control process (NO in step S12 of Fig. 2), controller 7 determines whether or not a predetermined condition is satisfied (step S15 of Fig. 2). When executing the first control process, controller 7 determines the condition of object 11 based on the reflected-wave electric power. In the present disclosure, the determining of the condition of object 11 based on the reflected-wave electric power is called "condition detection".

If the condition of object 11 is in a target condition, controller 7 determines that a predetermined condition is satisfied, and controller 7 allows the next process to start. When object 11 is a choux pastry or a souffle, the target condition is a swelled condition. In this case, the next process is the process of performing heating for baking object 11.

When the condition of object 11 reaches the target condition, controller 7 changes heating power or the like. When object 11 is a dried fruit, the target condition is a dried condition. In this case, controller 7 allows heating to end.

When controller 7 does not determine that temperature Ta no longer exceeds specified temperature Tp during execution of the second control process (NO in step S14 of Fig. 2), controller 7 determines whether or not a predetermined condition is satisfied (step S16 of Fig. 2).

In this step, controller 7 determines the condition of object 11 based on the reflected-wave electric power in one or more first periods when executing the second control process. If the condition of object 11 is in a target condition, controller 7 determines that a predetermined condition is satisfied, and controller 7 allows the next process to start.

When object 11 is a choux pastry or a souffle, the target condition is a swelled condition. In this case, the next process is the process of performing heating for baking object 11. Controller 7 changes heating power or the like. When object 11 is a dried fruit, the target condition is a dried condition. In this case, the next process is the process of stopping the heating means to end the heating.

As described above, in the present exemplary embodiment, the specific frequency at which a time variation of reflected-wave electric power G2 indicates a change in the condition of object 11 is associated with the first period, not with the second period. This prevents traveling-wave electric power G1 from becoming lower than first electric power W1.

When traveling-wave electric power G1 for the specific frequency becomes lower than first electric power W1 in the second control process, reflected-wave electric power G2 also decreases. Because the determination for a condition change of object 11 is made based on the reflected-wave electric power, there is a possibility that the accuracy of the determination may be lower in the second control process than in the first control process.

According to the present exemplary embodiment, the target value of traveling-wave electric power G1 at a specific frequency is set to first electric power W1, as in the first control process. As a result, the second control process is able to maintain the same level of determination accuracy as the first control process.

Second Exemplary Embodiment

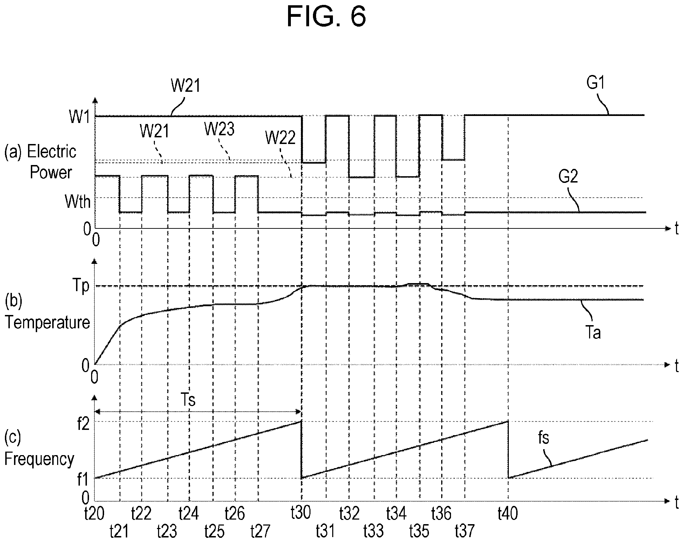

Hereinbelow, a second exemplary embodiment of the present disclosure will be described in detail with reference to Fig. 6. Radio wave emitting apparatus 1 according to the present exemplary embodiment has the same constituent elements as radio wave emitting apparatus 1 according to the first exemplary embodiment, but the operation of controller 7 differs from that of radio wave emitting apparatus 1 according to the first exemplary embodiment. Fig. 6 is a waveform chart illustrating an example of operation of controller 7 in radio wave emitting apparatus 1 according to the present exemplary embodiment. In Fig. 6, reference characters G1, G2, Ta, and fs represent the traveling-wave electric power, the reflected-wave electric power, the temperature of signal amplifier 3, and the frequency of traveling wave, respectively.

In the present exemplary embodiment, controller 7 determines the frequency to be associated with the first period and the frequency to be associated with the second period in the second control process based on reflected-wave electric power G2 measured when in the first control process.

Specifically, controller 7 performs this associating by determining whether or not reflected-wave electric power G2 is lower than or equal to predetermined electric power Wth when in the first control process. That is, controller 7 associates all the frequencies at which reflected-wave electric power G2 is lower than or equal to predetermined electric power Wth when in the first control process with the first period. Controller 7 also associates all the frequencies at which reflected-wave electric power G2 exceeds predetermined electric power Wth when in the first control process with the second period.

In Fig. 6, at time t30, controller 7 determines that temperature Ta has exceeded specified temperature Tp during execution of the first control process, and accordingly switches the operation of radio wave emitting apparatus 1 from the first control process to the second control process.

In Fig. 6, the first control process is executed from time t20 to t30. Time t20 to t30 corresponds to cycle period Ts of the frequency sweep for the traveling wave.

In Fig. 6, reflected-wave electric power G2 is lower than or equal to predetermined electric power Wth at a frequency contained in the period from time t21 to t22, at a frequency contained in the period from time t23 to t24, at a frequency contained in the period from time t25 to t26, and at a frequency contained in the period from time t27 to t30. All the frequencies contained in these periods are associated with the first period.

Accordingly, in the second control process, controller 7 associates the period from time t31 to t32, which is cycle period Ts after the period of time t21 to time t22, with the first one of the first periods. Controller 7 associates the period from time t33 to t34, which is cycle period Ts after the period of time t23 to time t24, with the second one of the first periods. Controller 7 associates the period from time t35 to t36, which is cycle period Ts after the period of time t25 to time t26, with the third one of the first periods. Controller 7 associates the period from time t37 to t40, which is cycle period Ts after the period of time t27 to time t30, with the fourth one of the first periods.

In Fig. 6, reflected-wave electric power G2 exceeds predetermined electric power Wth at a frequency contained in the period from time t20 to t21, at a frequency contained in the period from time t22 to t23, at a frequency contained in the period from time t24 to t25, and at a frequency contained in the period from time t26 to t27. All the frequencies contained in these periods are associated with the second period.

Accordingly, in the second control process, controller 7 associates the period from time t30 to t31, which is cycle period Ts after the period of time t20 to time t21, with the first one of the second periods. Controller 7 associates the period from time t32 to t33, which is cycle period Ts after the period of time t22 to time t23, with the second one of the second periods. Controller 7 associates the period from time t34 to t35, which is cycle period Ts after the period of time t24 to time t25, with the third one of the second periods. Controller 7 associates the period from time t36 to t37, which is cycle period Ts after the period of time t26 to time t27, with the fourth one of the second periods.

As described above, in radio wave emitting apparatus 1 of the present exemplary embodiment, in the second control process, each of one or more first periods is associated with a frequency at which reflected-wave electric power G2 is lower than or equal to predetermined electric power Wth when in the first control process. Each of one or more second periods is associated with a frequency at which reflected-wave electric power G2 exceeds predetermined electric power Wth when in the first control process. This configuration makes it possible to improve the efficiency of use of electric power based on the reflected-wave electric power.

In the present exemplary embodiment, as indicated by waveforms (a) and (b) in Fig. 3, temperature Ta no longer exceeds specified temperature Tp after time t36 onward because of the above-described control. Therefore, controller 7 switches the operation of radio wave emitting apparatus 1 from the second control process to the first control process after time t40 onward. That is, the second control process is performed only in the period from time t30 to t40.

However, the present disclosure is not limited to the present exemplary embodiment. Controller 7 may continue the above-described control as long as temperature Ta exceeds specified temperature Tp after time t40.

That is, all the frequencies contained in a certain period of the second control process after a time that is N times the cycle period Ts from a certain period of the first control process, in which reflected-wave electric power G2 exceeds predetermined electric power Wth, are associated with the first periods. On the other hand, all the frequencies contained in another period of the second control process after a time that is N times the cycle period Ts from another period of the first control process, in which reflected-wave electric power G2 does not exceed predetermined electric power Wth, are associated with the second periods. Here, the number N is a natural number.

In other words, one period of the second control process after a time N times the cycle period Ts from a certain period of the first control process means one period of the second control process that has the same phase as a certain period of the first control process in cycle period Ts.

Third Exemplary Embodiment

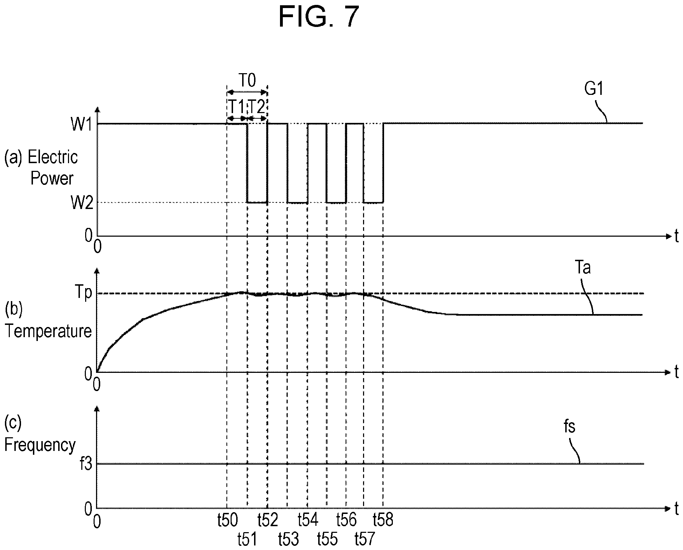

Hereinbelow, a third exemplary embodiment of the present disclosure will be described in detail with reference to Fig. 7. Radio wave emitting apparatus 1 according to the present exemplary embodiment has the same constituent elements as radio wave emitting apparatus 1 according to the first exemplary embodiment, but the operation of controller 7 differs from that of radio wave emitting apparatus 1 according to the first exemplary embodiment. Fig. 7 is a waveform chart illustrating an example of operation of controller 7 in radio wave emitting apparatus 1 according to the present exemplary embodiment. In Fig. 7, reference characters G1, Ta, and fs represent the traveling-wave electric power, the temperature of signal amplifier 3, and the frequency of the traveling wave, respectively.

In the present exemplary embodiment, each of the first control process and the second control process includes maintaining the frequency of the traveling wave at a target frequency. In the example of Fig. 7, controller 7 sets frequency fs of traveling wave to target frequency f3. Target frequency f3 is determined, for example, according to the type of object 11.

For example, memory storage 8 stores the associations between the types of object 11 and target frequencies f3. Controller 7 determines target frequency f3 based on these associations. Controller 7 may determine target frequency f3 in response to the input from input/output unit 9.

The first control process is a process with its primary purpose of emitting a radio wave to object 11. As illustrated in Fig. 7, the first control process includes setting the target value of traveling-wave electric power G1 to first electric power W1.

First electric power W1 is determined according to, for example, the content of the processing to be performed for object 11. First electric power W1 may be, for example, 250 W. In the present exemplary embodiment, the frequency of the traveling wave and the traveling-wave electric power are constant in the first control process.

In Fig. 7, at time t50, controller 7 determines that temperature Ta has exceeded specified temperature Tp during execution of the first control process, and accordingly switches the operation of radio wave emitting apparatus 1 from the first control process to the second control process.

A primary purpose of the second control process is to enable emission of radio wave to object 11 to continue while preventing the temperature of signal amplifier 3 from rising. The second control process includes providing one or more first periods and one or more second periods so that temperature Ta is maintained at a target temperature that is lower than or equal to specified temperature Tp. The second control process includes repeating the one or more first periods and the one or more second periods alternately one by one.

In the present exemplary embodiment, the target temperature matches specified temperature Tp. However, considering margins, the target temperature may be lower than specified temperature Tp.

In the first period, controller 7 sets the target value of the traveling-wave electric power G1 to first electric power W1. In other words, in the first period, controller 7 executes the same process as the first control process. In Fig. 7, a period from time t50 to t51, a period from time t52 to t53, and a period from time t54 to t55, and a period from time t56 to t57 correspond to the first period.

In the second period, controller 7 sets the target value of the traveling-wave electric power to second electric power W2 that is less than first electric power W1. The second control process includes setting second electric power W2 so as to maintain temperature Ta at the target temperature (specified temperature Tp herein). In Fig. 7, a period from time t51 to t52, a period from time t53 to t54, and a period from time t55 to t56, and a period from time t57 to t58 correspond to the second period.

Second electric power W2 is the electric power for maintaining temperature Ta to specified temperature Tp, or making temperature Ta lower than specified temperature Tp. Second electric power W2 is a fixed value.

T1 is the time width of one of the first periods, T2 is the time width of one of the second periods, and T0 is the total time width thereof. Time width T0 may vary depending on, for example, a cooking process (the condition of object 11). In the second control process, controller 7 adjusts the average value of traveling-wave electric power G1 by adjusting the ratio of time width T1 and time width T2. Thereby, temperature Ta is maintained at a target temperature that does not exceed specified temperature Tp.

The average value of the traveling-wave electric power is: (W1 × T1 + W2 × T2)/(T1 + T2). The ratio of time width T1 and time width T2 is expressed, for example, as: T1/(T1 + T2). That is, in the second control process, controller 7 controls the traveling-wave electric power using PWM (pulse width modulation) control.

In the present exemplary embodiment, controller 7 determines the ratio of electric time width T1 and time width T2 based on reduction amount D that is necessary to maintain temperature Ta at a target temperature. Reduction amount D is obtained, for example, according to the following equation (3).

[Eq. 2]

$$D = 10 \times \log_{10} Pdet_i - 10 \times \log_{10}(Pdet - Pdown) \qquad (3)$$

Pdet [W] represents the traveling-wave electric power. Pdown [W] is obtained by: Pdown = (Ta - Tq) × 1/Z. Tq is the target temperature, and Z is the thermal resistance of signal amplifier 3. Thermal resistance Z of signal amplifier 3 is represented by, for example, the thermal resistance between the junction of the semiconductor element of signal amplifier 3 and the case of signal amplifier 3.

Accordingly, the ratio of time width T1 and time width T2 in the first period may be set so that the average electric power becomes a value obtained by subtracting reduction amount D from first electric power W1.

As described above, in radio wave emitting apparatus 1 of the present exemplary embodiment, each of the first control process and the second control process includes maintaining the frequency of the traveling wave at a target frequency. Second electric power W2 is a fixed value.

In the second control process, controller 7 adjusts the average value of the traveling-wave electric power by adjusting the ratio of the length of each of the one or more first periods to the length of each of the one or more second periods. Thereby, temperature Ta is maintained at a target temperature that does not exceed specified temperature Tp. This configuration makes it possible to prevent an excessive temperature rise in signal amplifier 3 and to improve stability in the processes that are based on the reflected wave.

Fourth Exemplary Embodiment

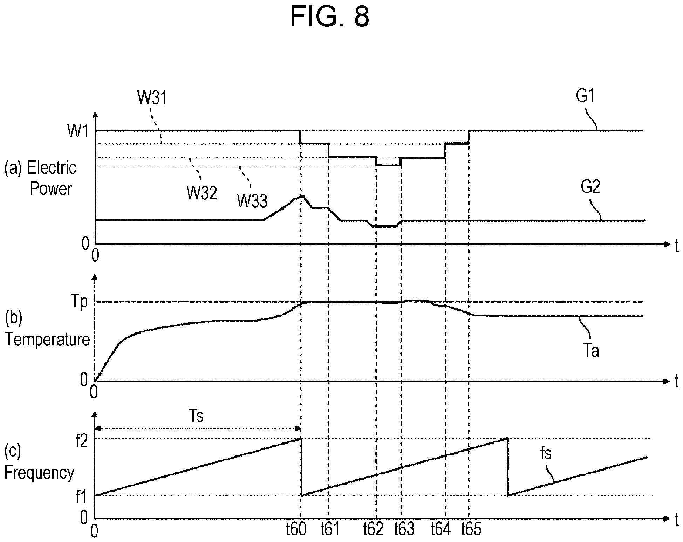

Hereinbelow, a fourth exemplary embodiment of the present disclosure will be described in detail with reference to Fig. 8. Radio wave emitting apparatus 1 according to the present exemplary embodiment has the same constituent elements as radio wave emitting apparatus 1 according to the first exemplary embodiment, but the operation of controller 7 differs from that of radio wave emitting apparatus 1 according to the first exemplary embodiment. Fig. 8 is a waveform chart illustrating an example of operation of controller 7 in radio wave emitting apparatus 1 according to the present exemplary embodiment. In Fig. 8, reference characters G1, G2, Ta, and fs represent the traveling-wave electric power, the reflected-wave electric power, the temperature of signal amplifier 3, and the frequency of traveling wave, respectively.

In the present exemplary embodiment, controller 7 is able to execute a third control process, in place of the second control process in the first to third exemplary embodiments, depending on the type of object 11. Memory storage 8 stores a data table that associates types of object 11 with the second control process or the third control process. Controller 7 references this data table to recognize whether the type of object 11 is associated with the second control process or the third control process.

When the type of object 11 is associated with the second control process, controller 7 switches the operation of radio wave emitting apparatus 1 to the second control process if it determines that temperature Ta has exceeded specified temperature Tp during execution of the first control process. When the type of object 11 is associated with the third control process, controller 7 switches the operation of radio wave emitting apparatus 1 to the third control process if it determines that temperature Ta has exceeded specified temperature Tp during execution of the first control process.

As illustrated in Fig. 8, until time t60, controller 7 executes the first control process, in which the target value of traveling-wave electric power G1 is set to first electric power W1, as in the foregoing exemplary embodiments. At time t60, controller 7 determines that temperature Ta has exceeded specified temperature Tp during execution of the first control process, and accordingly switches the operation of radio wave emitting apparatus 1 from the first control process to the third control process.

The third control process includes generating a high frequency signal while performing a frequency sweep, as in the first control process and the second control process.

A primary purpose of the third control process is, as with the second control process, to enable emission of a radio wave to object 11 to continue while preventing the temperature of signal amplifier 3 from rising. The third control process includes constantly setting the target value of traveling-wave electric power G1 to an electric power within a specified range that is lower than first electric power W1, so as to maintain temperature Ta at the target temperature lower than or equal to specified temperature Tp.

As illustrated in Fig. 8, in a period from time t60 to t61, a period from time t61 to 62, a period from time 62 to 63, a period from time t63 to t64, and a period from time t64 to 65, the target value of traveling-wave electric power G1 is set to electric power W31, W32, W33, W32, and W31, respectively.

Electric power W31, electric power W32, and electric power W33 are all within a specified range. Electric power W32 is higher than electric power W33 but lower than electric power W31. In the third control process, the electric power within the specified range, which is the target value of traveling-wave electric power G1, is determined, for example, in the same manner as that is used in determining the second electric power described in the first exemplary embodiment using equations (1) and (2) above.

As indicated by waveform (c) of Fig. 8, the target value of traveling-wave electric power G1 is set to first electric power W1 in the first control process until time t60. In the present exemplary embodiment, controller 7 executes the third control process after time t60 onward. Unlike the second control process in the first to third exemplary embodiments, the third control process does not contain a period in which the target value of traveling-wave electric power G1 is set to first electric power W1. In the third control process, the target value of traveling-wave electric power G1 is constantly set to an electric power that is within a specified range that is lower than first electric power W1.

As an example, when the type of object 11 is frozen food and the purpose of dielectric heating is defrosting, first electric power W1 is set relatively low in the first control process. In this case, temperature Ta may in some cases be difficult to maintain at a target temperature when a period in which the target value of traveling-wave electric power G1 is set to first electric power W1 (i.e., the first period in the first to third exemplary embodiments) is provided, as in the second control process of the first to third exemplary embodiments.

When first electric power W1 is relatively low in the first control process, a decrease in traveling-wave electric power G1 has a small effect on reflected-wave electric power G2. For this reason, controller 7 may execute the third control process of the present exemplary embodiment in place of the second control process in the first to third exemplary embodiments, in order to maintain temperature Ta at a target temperature. The third control process is able to maintain temperature Ta at a target temperature more easily than the second control process, but is more likely to reduce the stability of the processes that are based on reflected-wave electric power G2.

As described above, in radio wave emitting apparatus 1 of the present exemplary embodiment, controller 7 executes the third control process in place of the second control process, depending on the type of object 11. The third control process includes constantly setting traveling-wave electric power G1 to an electric power within a specified range that is lower than the first electric power, so as to maintain temperature Ta at the target temperature. This configuration enables the control process to be executed according to the type of object 11.

Modified Examples

Embodiments of the present disclosure are not limited to the exemplary embodiments described above. The following describes modified examples of the foregoing exemplary embodiments. It is also possible that each of the following modified examples may be combined with the foregoing exemplary embodiments and other modified examples as appropriate.

In one modified example, controller 7 determines the frequency associated with the first period and the frequency associated with the second period in the second control process, based on whether it is needed to provide a target electric field distribution in cavity 10.

In radio wave emitting apparatus 1, different electric field distributions are formed inside cavity 10 depending on the frequency of the traveling wave. For this reason, controller 7 sets the second period not to contain a period of the frequencies that are necessary to form a desirable electric field distribution for object 11. This makes it possible to emit a radio wave to object 11 appropriately in the second control process.

Controller 7 associates each of the frequencies in the predetermined frequency band with the first period or the second period so that the first period contains the frequencies that are necessary to provide a target electric field distribution in cavity 10. The target electric field distribution is determined, for example, according to the type of object 11. Memory storage 8 may store associations between the target electric field distributions and the types of object 11.

As an example, it is assumed that the predetermined frequency band is 2400 MHz to 2499 MHz, and the frequency band that is necessary to provide the target electric field distribution is 2460 MHz to 2469 MHz.

In this case, the first period may be associated with frequency bands of 2400 MHz to 2409 MHz, 2420 MHz to 2429 MHz, 2440 MHz to 2449 MHz, 2460 MHz to 2469 MHz, and 2480 MHz to 2489 MHz.

The second period may be associated with frequency bands of 2410 MHz to 2419 MHz, 2430 MHz to 2439 MHz, 2450 MHz to 2459 MHz, 2470 MHz to 2479 MHz, 2490 MHz to 2499 MHz.

In this way, at least one of the one or more first periods is associated with one of the frequencies that is necessary to provide the target electric field distribution in cavity 10. Each of the one or more second periods is associated with one of the frequencies that is not necessary to provide the target electric field distribution in the cavity. This configuration makes it possible to emit a radio wave to object 11 appropriately in the second control process.

As one modified example, in the second or third exemplary embodiment, controller 7 may execute the third control process in place of the second control process depending on the type of object 11. When the third control process is executed in the third exemplary embodiment, the third control process includes maintaining the frequency of the traveling wave at a target frequency, as in the first control process and the second control process. The frequency controlling is common in the first control process, the second control process, and the third control process. Controller 7 may execute the third control process in place of the second control process in response to the input from input/output unit 9.

As a third modified example, radio wave emitting apparatus 1 may include an additional processing means. The additional processing means may be another heating means or another high-frequency electric power generating means. The other heating means may be, for example, radiation heating. In this case, it is possible to perform processing in which radiation heating and dielectric heating are combined. The other high-frequency electric power generating means may be, for example, a magnetron. In this case, it is possible to perform processing in which two different high-frequency electric power generating means are combined.

In one modified example, first electric power W1 may not necessarily be constant. First electric power W1 may be varied as appreciated depending on the type of object 11, the elapsed time from the start of processing, the condition of object 11, and the like.

Embodiments and Advantageous Effects

Radio wave emitting apparatus 1 according to a first aspect of the present disclosure includes signal generator 2, signal amplifier 3, radio wave emitter 4, temperature measurer 5, electric power measurer 6, and controller 7.

Signal generator 2 generates a high frequency signal having a given frequency in a predetermined frequency band. Signal amplifier 3 amplifies the high frequency signal to generate a high frequency electric power. Radio wave emitter 4 emits a traveling wave corresponding to the high frequency electric power to object 11. Temperature measurer 5 measures temperature Ta of signal amplifier 3. Electric power measurer 6 measures a reflected-wave electric power, which is the electric power of a reflected wave of the traveling wave that returns to radio wave emitter 4. Controller 7 controls signal generator 2 and signal amplifier 3.

Controller 7 is operable to execute a first control process and a second control process. The first control process includes setting a target value of a traveling-wave electric power, which is the electric power of the traveling wave, to a first electric power. The second control process includes providing one or more first periods during which the target value of the traveling-wave electric power is set to the first electric power, and one or more second periods during which the target value of the traveling-wave electric power is set to a second electric power that is less than the first electric power. The second control process includes repeating the one or more first periods and the one or more second periods alternately one by one. Controller 7 executes the second control process when temperature Ta of signal amplifier 3 exceeds specified temperature Tp during execution of the first control process.

This aspect makes it possible to maintain temperature Ta of signal amplifier 3 at a target temperature that does not exceed specified temperature Tp. As a result, it is possible to prevent an excessive temperature rise in signal amplifier 3 and to improve stability in the processes that are based on the reflected wave.

A second aspect of the present disclosure is radio wave emitting apparatus 1 in accordance with the first aspect. In the second aspect, controller 7 determines a condition of object 11 based on the reflected-wave electric power when executing the first control process, and determines the condition of object 11 based on the reflected-wave electric power in the one or more first periods when executing the second control process.

This aspect makes it possible to prevent an excessive temperature rise in signal amplifier 3 and to improve stability in the determination of the condition of object 11.

A third aspect of the present disclosure is radio wave emitting apparatus 1 in accordance with the first or second aspect. In the third aspect, each of the first control process and the second control process includes a frequency sweep repeatedly and periodically changing the frequency of the high frequency signal over the predetermined frequency band. The second control process includes adjusting the second electric power to maintain temperature Ta of signal amplifier 3 at a target temperature that does not exceed specified temperature Tp. The second control process includes associating each of the one or more first periods with a corresponding one of frequencies in the predetermined frequency band, and associating each of the one or more second periods with a corresponding one of the frequencies in the predetermined frequency band.

This aspect makes it possible to prevent an excessive temperature rise in signal amplifier 3 and to improve stability of the processes that are based on the reflected wave.

A fourth aspect of the present disclosure is radio wave emitting apparatus 1 in accordance with the third aspect. In the fourth aspect, the associating each of the one or more first periods with the corresponding one of the frequencies in the predetermined frequency band is determined according to a type of the object. The associating each of the one or more second periods with the corresponding one of the frequencies in the predetermined frequency band is determined according to the type of object 11. This aspect enables the control process to be executed according to the type of object 11.

A fifth aspect of the present disclosure is radio wave emitting apparatus 1 in accordance with the third or fourth aspect. In the fifth aspect, at least one of the one or more first periods is associated with a specific frequency within the predetermined frequency band. The specific frequency is a frequency at which a time variation of the reflected-wave electric power indicates a change in the condition of object 11. This aspect makes it possible to further improve stability of the processes that are based on the reflected wave.

A sixth aspect of the present disclosure is radio wave emitting apparatus 1 in accordance with the third aspect. In the sixth aspect, each of the one or more first periods is associated with a frequency at which the reflected-wave electric power is lower than or equal to a predetermined electric power when in the first control process. Each of the one or more second periods is associated with a frequency at which the reflected-wave electric power exceeds the predetermined electric power when in the first control process. This aspect improves the efficiency of use of electric power.

A seventh aspect of the present disclosure is radio wave emitting apparatus 1 in accordance with the third aspect. Radio wave emitting apparatus 1 of the seventh aspect further includes a cavity for accommodating object 11. At least one of the one or more first periods is associated with a frequency within the predetermined frequency band that is necessary to provide a target electric field distribution in cavity 10. Each of the one or more second periods is associated with a frequency within the predetermined frequency band that is not necessary to provide the target electric field distribution in cavity 10. This aspect makes it possible to emit an appropriate radio wave to object 11 in the second control process.

An eighth aspect of the present disclosure is radio wave emitting apparatus 1 in accordance with the first or second aspect. In the eighth aspect, each of the first control process and the second control process includes maintaining the frequency of the traveling wave at a target frequency. The second control process adjusts the average value of the traveling-wave electric power by adjusting the ratio of the length of each of the one or more first periods to the length of each of the one or more second periods so as to maintain temperature Ta of signal amplifier 3 at the target temperature that does not exceed specified temperature Tp. This aspect makes it possible to prevent an excessive temperature rise in signal amplifier 3 and to improve stability of the processes that are based on the reflected wave.

A ninth aspect of the present disclosure is radio wave emitting apparatus 1 in accordance with any one of the first to eighth aspects. In the ninth aspect, controller 7 executes a third control process in place of the second control process, depending on the type of object 11. The third control process includes constantly setting the traveling-wave electric power to an electric power within a specified range that is lower than the first electric power, so as to maintain temperature Ta at the target temperature. This aspect enables the control process to be executed according to the type of object 11.

A tenth aspect of the present disclosure is radio wave emitting apparatus 1 in accordance with any one of the first to ninth aspects. In the tenth aspect, controller 7 executes the first control process when temperature Ta of signal amplifier 3 no longer exceeds specified temperature Tp during execution of the second control process. This aspect makes it possible to prevent an excessive temperature rise in signal amplifier 3 and to improve stability of the processes that are based on the reflected wave.

## INDUSTRIAL APPLICABILITY

The present disclosure is applicable to radio wave emitting apparatuses, such as microwave ovens.

## REFERENCE MARKS IN THE DRAWINGS

1 radio wave emitting apparatus
2 signal generator

3    signal amplifier
4    radio wave emitter
5    temperature measurer
6    electric power measurer
7    controller
8    memory storage
9    input/output unit
10   cavity
11   object

**Claims**

1.  A radio wave emitting apparatus comprising:

    a signal generator configured to generate a high frequency signal with a given frequency in a predetermined frequency band;
    a signal amplifier configured to amplify the high frequency signal to generate a high frequency electric power;
    a radio wave emitter configured to emit a traveling wave corresponding to the high frequency electric power to an object;
    a temperature measurer configured to measure a temperature of the signal amplifier;
    an electric power measurer configured to measure a reflected-wave electric power being an electric power of a reflected wave of the traveling wave, the reflected wave returning to the radio wave emitter; and
    a controller configured to control the signal generator and the signal generator;

    wherein:

    the controller is operable to execute a first control process and a second control process;

        the first control process includes setting a target value of a traveling-wave electric power to a first electric power, the traveling-wave electric power being an electric power of the traveling wave; and
        the second control process includes providing one or more first periods during which the target value of the traveling-wave electric power is set to the first electric power and one or more second periods during which the target value of the traveling-wave electric power is set to a second electric power less than the first electric power, and the second control process includes repeating the one or more first periods and the one or more second periods alternately one by one;

    the controller is configured to execute the second control process when the temperature of the signal amplifier exceeds a specified temperature during execution of the first control process.

2.  The radio wave emitting apparatus according to claim 1, wherein:
    the controller is configured to:

        determine, when executing the first control process, a condition of the object based on the reflected-wave electric power; and
        determine, when executing the second control process, the condition of the object based on the reflected-wave electric power in the one or more first periods.

3.  The radio wave emitting apparatus according to claim 1 or 2, wherein:

        each of the first control process and the second control process includes a frequency sweep repeatedly and periodically changing the frequency of the high frequency signal over the predetermined frequency band;
        the second control process includes adjusting the second electric power to maintain the temperature of the signal amplifier at a target temperature not exceeding the specified temperature; and
        the second control process includes associating each of the one or more first periods with a corresponding one of frequencies in the predetermined frequency band, and associating each of the one or more second periods with a corresponding one of the frequencies in the predetermined frequency band.

4.  The radio wave emitting apparatus according to claim 3, wherein the associating each of the one or more first periods with the corresponding one of the frequencies in the predetermined frequency band is determined according to a type of the object, and the associating each of the one or more second periods with the corresponding one of the frequencies in the predetermined frequency band is determined according to the type of the object.

5. The radio wave emitting apparatus according to claim 3 or 4, wherein at least one of the one or more first periods is associated with a specific frequency within the predetermined frequency band, the specific frequency being a frequency at which a time variation of the reflected-wave electric power indicates a change in the condition of the object.

6. The radio wave emitting apparatus according to claim 3, wherein:

each of the one or more first periods is associated with a frequency at which the reflected-wave electric power is lower than or equal to a predetermined electric power when in the first control process; and
each of the one or more second periods is associated with a frequency at which the reflected-wave electric power exceeds the predetermined electric power when in the first control process.

7. The radio wave emitting apparatus according to claim 3, further comprising:
a cavity configured to accommodate the object; wherein:

at least one of the one or more first periods is associated with a frequency within the predetermined frequency band that is necessary to provide a target electric field distribution in the cavity; and
each of the one or more second periods is associated with a frequency within the predetermined frequency band that is not necessary to provide the target electric field distribution in the cavity.

8. The radio wave emitting apparatus according to claim 1 or 2, wherein:

each of the first control process and the second control process includes maintaining the frequency of the traveling wave to a target frequency; and
the second control process includes adjusting an average value of the traveling-wave electric power by adjusting a ratio of a length of each of the one or more first periods to a length of each of the one or more second periods.

9. The radio wave emitting apparatus according to any one of claims 1 to 8, wherein:

the controller executes a third control process in place of the second control process depending on a type of the object; and
the third control process includes constantly setting the traveling-wave electric power to an electric power within a specified range that is lower than the first electric power.

10. The radio wave emitting apparatus according to any one of claims 1 to 9, wherein the controller is configured to execute the first control process when the temperature of the signal amplifier not longer exceeds the specified temperature during execution of the second control process.

# FIG. 1

# FIG. 2

```
                          ┌──────────┐
                          │  Start   │
                          └──────────┘
                                │
                                ▼
        S11 │  First control process  │◄──────────────────────┐
                                │                              │
      Ⓐ ──────────────────────►│                              │
                                ▼                              │
        S12        ╱◇╲                                         │
              ╱ Temperature Ta > specified ╲   YES             │
             ╲   temperature Tp?  ╱─────────────────┐          │
                   ╲◇╱                               ▼          │
                    │ NO                 S13 │ Second control process │
                    ▼                               │          │
        S15       ╱◇╲                    Ⓑ ────────►│          │
           ╱ Predetermined condition ╲  NO          ▼          │
          ╲    satisfied?   ╱──────────┐   S14    ╱◇╲          │
                ╲◇╱                    ▼      ╱ Temperature Ta ≤ specified ╲ YES │
                 │ YES                Ⓐ      ╲  temperature Tp? ╱──────────┘
                 │                             ╲◇╱
                 │                              │ NO
                 │                              ▼
                 │                  S16       ╱◇╲
                 │                     ╱ Predetermined condition ╲ NO
                 │                    ╲    satisfied?  ╱──────────┐
                 │                          ╲◇╱                   ▼
                 │                           │ YES               Ⓑ
                 │◄─────────────────────────┘
                 ▼
            ┌──────────┐
            │   End    │
            └──────────┘
```

# FIG. 3

(a) Electric Power

W1
W22 W21 W23
G1
G2

(b) Temperature

Tp
Ta

(c) Frequency

Ts
f2
f1
fs

t10 t12 t14 t16 t20
t11 t13 t15 t17

# FIG. 4

(a) 2400~2409MHz

(b) 2410~2419MHz

(c) 2420~2429MHz

(d) 2430~2439MHz

(e) 2440~2449MHz

(f) 2450~2459MHz

(g) 2460~2469MHz

(h) 2470~2479MHz

(i) 2480~2489MHz

(j) 2490~2499MHz

# FIG. 5

# FIG. 6

(a) Electric Power

(b) Temperature

(c) Frequency

# FIG. 7

# FIG. 8

(a) Electric Power

W31
W32 W33
W1
G1
G2

(b) Temperature

Tp
Ta

(c) Frequency

Ts
f2
f1
fs

t60 t61 t62 t63 t64 t65

## INTERNATIONAL SEARCH REPORT

| | International application No. |
|---|---|
| | **PCT/JP2023/002465** |

**A.  CLASSIFICATION OF SUBJECT MATTER**

*H05B 6/68*(2006.01)i; *F24C 7/02*(2006.01)i
FI:  H05B6/68 320P; H05B6/68 320S; F24C7/02 320F

According to International Patent Classification (IPC) or to both national classification and IPC

**B.  FIELDS SEARCHED**

Minimum documentation searched (classification system followed by classification symbols)

H05B6/68; F24C7/02

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C.  DOCUMENTS CONSIDERED TO BE RELEVANT**

| Category* | Citation of document, with indication, where appropriate, of the relevant passages | Relevant to claim No. |
|---|---|---|
| Y | WO 2020/050356 A1 (PANASONIC INTELLECTUAL PROPERTY MANAGEMENT CO., LTD.) 12 March 2020 (2020-03-12) paragraphs [0012]-[0055], fig. 1-6 | 1-2, 8-10 |
| A | | 3-7 |
| Y | JP 7-077333 A (MATSUSHITA ELECTRIC IND. CO., LTD.) 20 March 1995 (1995-03-20) paragraphs [0020]-[0063] | 1-2, 8-10 |
| Y | JP 2018-142452 A (HITACHI APPLIANCES INC.) 13 September 2018 (2018-09-13) paragraph [0010] | 2, 8-10 |

☐ Further documents are listed in the continuation of Box C.   ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **15 February 2023** | **28 February 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**
Information on patent family members

International application No.

**PCT/JP2023/002465**

| Patent document cited in search report | | | Publication date (day/month/year) | Patent family member(s) | Publication date (day/month/year) |
|---|---|---|---|---|---|
| WO | 2020/050356 | A1 | 12 March 2020 | US 2021/0274609 A1 paragraphs [0019]-[0066], fig. 1-6 CN 112470550 A | |
| JP | 7-077333 | A | 20 March 1995 | US 5491323 A column 4, line 51 to column 13, line 32 | |
| JP | 2018-142452 | A | 13 September 2018 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2014188422 A